(19) Europäisches Patentamt
European Patent Office
Office européen des brevets

(11) **EP 3 598 160 A1**

(12) **EUROPÄISCHE PATENTANMELDUNG**

(43) Veröffentlichungstag:
**22.01.2020 Patentblatt 2020/04**

(51) Int Cl.:
*G01R 33/54* *(2006.01)*      *G06K 9/32* *(2006.01)*

(21) Anmeldenummer: 18183865.7

(22) Anmeldetag: **17.07.2018**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Siemens Healthcare GmbH**
**91052 Erlangen (DE)**

(72) Erfinder:
• **Kartäusch, Ralf**
  **91058 Erlangen (DE)**
• **Zeller, Mario**
  **91054 Erlangen (DE)**

(54) **PARAMETEROPTIMIERUNG FÜR MAGNETRESONANZBILDGEBUNGSAUFNAHMEN**

(57)  Die Erfindung betrifft ein Verfahren zur Aufnahme eines optimierten MR-Bildes wobei mehrere Testbilder (41-44) mit unterschiedlichen Parametersätzen aufgenommen werden und das MR-Testbild ausgesucht wird, das den besten Kontrast hat. Die Bildgebungsparameter des ausgesuchten MR-Testbildes werden dann für die Aufnahme des optimierten MR-Bildes verwendet.

# FIG 2

EP 3 598 160 A1

**Beschreibung**

Die vorliegende Erfindung betrifft ein Verfahren zum Aufnehmen von einem optimierten MR-Bild eines Untersuchungsobjekts in einer Magnetresonanzanlage. Weiterhin wird die zugehörige Magnetresonanzanlage, ein Computerprogrammprodukt und ein elektronisch-lesbarer Datenträger bereitgestellt.

Ein Vorteil der Magnetresonanztomographie, MRT, gegenüber anderen bildgebenden Techniken ist die hohe Differenzierbarkeit von Gewebetypen. Die Differenzierbarkeit lässt sich meist ausreichend durch die beiden Relaxationszeiten T1 und T2, die Protonendichte und die Diffusion beschreiben. Läsionen wie beispielsweise verschiedene Tumorarten lassen sich aufgrund dieser Parameter klassifizieren, und entsprechende Therapien können ausgewählt werden. Die einzelnen Parameter oder auch die Kombination mehrerer Parameter werden üblicherweise durch Helligkeitsänderungen in den erzeugten MR-Bildern sichtbar gemacht. Die Bedienperson der Magnetresonanzanlage versucht entsprechend der zu erwartenden Läsion oder der zu untersuchenden Region möglichst signifikante Kontrastunterschiede zu erreichen, beispielsweise durch Wahl von Echozeiten, HF-Kippwinkeln, Repetitionszeiten etc.

Da aber vorab die Tumorart zumeist nicht bekannt ist, werden hierfür Bildgebungsparameter gewählt, die voraussichtlich im Allgemeinen gute Ergebnisse liefern. Selbst wenn es bekannt ist, um welche Läsion es sich handelt, bedarf es im Normalfall sehr erfahrene Bedienpersonen bzw. passend abgelegte Protokolle, um einen möglichst guten Kontrast in einem Interessenbereich, wo eine medizinische Fragestellung beantwortet werden soll, zu erreichen. Üblicherweise werden aufgrund von wirtschaftlichen Voraussetzungen einige möglichst universelle MR-Bilddatensätze mit unterschiedlichen Kontrasten aufgenommen. Dies führt jedoch zu einer schlechteren Diagnostizierbarkeit im Vergleich zu einer spezifisch abgestimmten Wahl der Einstellung der Bildgebungsparameter.

Es ist daher eine Aufgabe der vorliegenden Erfindung ein Verfahren bzw. eine Magnetresonanzanlage bereitzustellen, wobei der auf die medizinische Fragestellung abgestimmte optimale Kontrast in den aufgenommenen MR-Bildern erreicht wird.

Diese Aufgabe wird durch die Merkmale der unabhängigen Ansprüche gelöst. In den abhängigen Ansprüchen sind weitere Ausführungsformen der Erfindung beschrieben.

Gemäß einem ersten Aspekt wird ein Verfahren zum Aufnehmen von einem optimierten MR-Bild eines Untersuchungsobjekts in einer Magnetresonanzanlage bereitgestellt, wobei in einem Schritt zumindest ein MR-Übersichtsbild des Untersuchungsobjekts bestimmt wird. Weiterhin wird ein Interessenbereich im Untersuchungsobjekt auf dem MR-Übersichtsbilds bestimmt, der in dem optimierten MR-Bild dargestellt sein soll. Zusätzlich werden mehrere MR-Testbilder mit jeweils einem Bildgebungsparametersatz aufgenommen, wobei sich die Bildgebungsparametersätze bei den mehreren MR-Testbildern in zumindest einem Bildgebungsparameter unterscheiden und wobei in den MR-Testbildern der Interessenbereich abgebildet ist. Es wird ein Bildqualitätsparameter in dem Interessenbereich in den mehreren MR-Testbildern bestimmt und es wird das MR-Testbild unter den MR-Testbildern, d.h. ein erstes MR-Testbild bestimmt, das den besten Bildqualitätsparameter aufweist, wobei der erste Bildgebungsparametersatz bestimmt wird, der bei der Erstellung des ersten MR-Testbildes verwendet wurde. Anschließend wird das optimierte MR-Bild mit einem optimierten Bildgebungsparametersatz aufgenommen, bei dem die Mehrzahl der verwendeten Bildgebungsparameter den Bildgebungsparametern des ersten Bildgebungsparametersatzes entspricht. Die Dauer für die Aufnahme des optimierten MR-Bildes ist hierbei größer als die Dauer für die Aufnahme der mehreren MR-Testbilder.

Vorzugsweise werden die meisten oder alle der oben genannten Schritten automatisch durchgeführt, insbesondere die Schritte des Bestimmens des Interessenbereichs, das Bestimmen des Bildqualitätsparameters und das Bestimmen des ersten MR-Testbildes, so dass automatisiert der Bildgebungsparametersatz bestimmt werden kann, der zu dem besten MR-Testbild führt, wodurch es möglich ist, das optimierte MR-Bild aufzunehmen, das den gewünschten Kontrast im Interessenbereich aufweist. Mit dem oben beschriebenen Verfahren ist es möglich eine höhere Unabhängigkeit von der Erfahrung der Bedienperson bei der Bestimmung des optimierten MR-Bildes zu erreichen.

Jeder Bildgebungsparametersatz kann kontrastbestimmende Parameter aufweisen, die überwiegend einen Kontrast von aufgenommenen MR-Bildern bestimmen und auflösungsbestimmende Parameter, die überwiegend eine Auflösung von den aufgenommenen MR-Bildern bestimmen. Hierbei können die kontrastbestimmenden Parameter des ersten Bildgebungsparametersatzes für die Aufnahme des optimierten MR-Bildes verwendet werden. Da ein Kontrastverhältnis als Bildqualitätsparameter verwendet werden kann, weist das erste MR-Testbild unter den Testbildern das beste Kontrastverhältnis auf. Somit ist es wünschenswert, für die Aufnahme des optimierten MR-Bildes zumindest die Bildgebungsparameter des ersten MR-Testbildes zu verwenden, die zu einem optimierten Kontrast im ersten MR-Testbild geführt haben. Die auflösungsbestimmenden Parameter können aber müssen nicht übernommen werden zur Bestimmung des optimierten MR-Bildes, da es möglich ist, dass die MR-Testbilder mit einer deutlich geringeren Auflösung aufgenommen werden als letztendlich das optimierte MR-Bild.

Vorzugsweise ist damit die Auflösung bei den MR-Testbildern geringer als die Auflösung des optimierten MR-Bildes.

Es ist jedoch auch möglich, dass die Anregung bei den MR-Testbildern auf einen kleinen geometrischen Bereich, nämlich den Interessenbereich im Wesentlichen beschränkt wird, beispielsweise durch Wahl von geeigneten HF-Pulsen in mehreren HF-Kanälen. In einem derartigen Fall kann das MR-Testbild die gleiche oder eine ähnliche Auflösung haben wie das optimierte MR-Bild.

Der Interessenbereich kann beispielsweise automatisch ausgewählt werden unter Verwendung von Antwortdaten, die Antworten auf medizinische Fragestellungen aufweisen, die der MR-Anlage zugeführt wurden, wobei die Antworten beispielsweise von einer Bedienperson gegeben wurden. Hierbei ist es möglich, dass der Interessenbereich automatisch von einem neuronalen Netzwerk bestimmt wird, dem die Antwortdaten zugeführt wurden. Hierbei ist es möglich, ein neuronales Netz in Abhängigkeit von den medizinischen Fragestellungen auszuwählen, welches mit bestehenden MR-Daten von Pathologien trainiert wurde. Das neuronale Netz kann dann den Interessenbereich automatisch auswählen.

Weiterhin ist es möglich, bei der Aufnahme der MR-Testbilder Projektionsbilder zu erzeugen, die mit Magnetfeldgradienten in weniger Raumrichtungen aufgenommen werden als bei der Aufnahme des optimierten MR-Bildes. Durch diese Projektionsbilder kann die Aufnahmezeit der mehreren MR-Testbilder weiter verkürzt werden. Insgesamt sollte die Aufnahmezeit für die Dauer der Aufnahme der mehreren MR-Testbilder deutlich geringer sein als die Dauer für die Aufnahme des optimierten MR-Bildes, beispielsweise kann die Dauer für die Aufnahme der MR-Testbilder um den Faktor 5-10 geringer sein als die Dauer für die einzelne Aufnahme des optimierten MR-Bildes. Weiterhin ist es möglich, dass die Dauer für die Aufnahme der ersten MR-Testbilder unter einem bestimmten Wert liegt, d.h. die Dauer kleiner als beispielsweise 20 Sekunden oder kleiner als 10 Sekunden ist.

Mit den unterschiedlichen Bildgebungsparametern der MR-Testbilder kann ein Parameterraum aufgespannt werden, der mit den MR-Testbildern und den unterschiedlichen Bildgebungsparametern abgetastet wird. Für die Bestimmung des ersten MR-Testbildes mit dem besten Bildqualitätsparameter können nun frühere Parameterräume und frühere erste Bildgebungsparametersätze verwendet werden, die bei der Bestimmung von früheren optimierten MR-Bildern verwendet wurden, um bei der Abtastung des Parameterraums den Punkt im Parameterraum schneller zu finden, der dem besten Bildqualitätsparameter im Interessenbereich entspricht.

Hierbei ist es möglich das erste MR-Testbild zu bestimmen unter Verwendung eines neuronalen Netzes, das mit den früheren Parameterräumen und den früheren ersten Bildgebungsparametersätzen trainiert wurde, damit das erste Testbild schneller gefunden wird, d.h. das Verfahren schneller konvergiert und somit weniger Testbilder aufgenommen werden müssen.

Zur Bestimmung des Bildqualitätsparameters kann ein Profil der Signalintensität im Interessenbereich bestimmt werden, wobei der Bildqualitätsparameter anhand des zumindest einem Profils bestimmt wird, beispielsweise unter Bestimmung einer maximalen Ableitung des bestimmten Profils oder, bei Verwendung von mehreren Profilen, einer Maximierung der verschiedenen bestimmten Kontrastverhältnisse.

Mithilfe des Profils ist es möglich, eine Zielfunktion zu bestimmen, wobei zur Bestimmung des ersten MR-Testbildes auf die Zielfunktion ein Optimierungsverfahren angewandt wird, beispielsweise ein Gradientenabstiegsverfahren. Hierfür werden iterativ Testbilder aufgenommen, und durch das Gradientenabstiegsverfahren wird geklärt, wie die Parameter zwischen den einzelnen Bildern geändert werden.

Weiterhin ist es möglich, dass das optimierte MR-Bild in mehreren Schichten aufgenommen wird, wobei jedes der Testbilder nur in einer Schicht oder in weniger Schichten als das optimierte MR-Bild aufgenommen wird.

Zusätzlich wird eine Magnetresonanzanlage bereitgestellt, die ausgebildet ist zur Aufnahme von MR-Bildern, wobei die Magnetresonanzanlage eine Steuereinheit und eine Speichereinheit aufweist, wobei die Speichereinheit von der Steuereinheit ausführbare Steuerinformationen speichert, wobei die Magnetresonanzanlage ausgebildet ist bei der Ausführung der Steuerinformationen in der Steuereinheit das oben beschriebene Verfahren durchzuführen.

Zusätzlich wird ein Computerprogrammprodukt bereitgestellt welches Programmmittel umfasst und direkt in eine Speichereinheit einer programmierbaren Steuereinheit einer Magnetresonanzanlage ladbar ist, um die Schritte des oben beschriebenen Verfahren auszuführen wenn die Programmmittel in der Steuereinheit ausgeführt werden.

Ebenso wird ein elektronisch-lesbarer Datenträger bereitgestellt mit darauf gespeicherten elektronisch-lesbaren Steuerinformationen. Diese sind derart ausgebildet, dass sie bei Verwendung des Datenträgers in einer Steuereinheit einer Magnetresonanzanlage ein Verfahren wie oben beschrieben durchführen.

Die oben dargelegten Merkmale und die nachfolgend beschriebenen Merkmale können nicht nur in den entsprechenden explizit dargelegten Kombination verwendet werden, sondern auch in anderen Kombinationen sofern es nicht explizit anders erwähnt ist, ohne den Schutzumfang der Erfindung zu verlassen.

Die Erfindung wird nachfolgend unter Bezugnahme auf die beiliegenden Zeichnungen näher erläutert.

Figur 1 zeigt schematisch eine MR-Anlage mit der erfindungsgemäß ein optimiertes MR-Bild aufgenommen werden kann mit optimierten Kontrast in einem Interessenbereich.

Figur 2 zeigt schematisch ein Interessenbereich in dem verschiedene Intensitätsprofile bestimmt wurden zur Bestimmung eines Bildqualitätsparameters in MR-Testbildern.

Figur 3 zeigt schematisch mehrere aufgenommene MR-Testbilder die mit unterschiedlichen Bildgebungsparametern aufgenommen wurden zur Auswahl eines des Bildes mit bestem Bildqualitätsparameter durch eine Bedienperson.

Figur 4 zeigt schematisch ein Flussdiagramm mit den Schritten, die durchgeführt werden können zur Aufnahme eines optimierten MR-Bildes.

Nachfolgend wird die vorliegende Erfindung anhand bevorzugter Ausführungen unter Bezugnahme auf die beiliegenden Zeichnungen näher erläutert. In den Figuren bezeichnen gleiche Bezugszeichen gleiche oder ähnliche Elemente. Weiterhin sind die Figuren schematische Darstellungen verschiedener Ausführungsformen der Erfindung. Die in den Figuren dargestellten Elemente sind nicht notwendigerweise maßstabsgetreu dargestellt, sondern sind vielmehr derart wiedergegeben, dass ihre Funktion und ihr Zweck für den Fachmann verständlich werden. Die in den Figuren dargestellten Verbindungen zwischen funktionellen Einheiten oder sonstigen Elementen können auch als indirekte Verbindung implementiert werden, wobei eine Verbindung drahtlos oder drahtgebunden sein kann. Funktionelle Einheiten können als Hardware, Software, Firmware, oder eine Kombination davon implementiert werden.

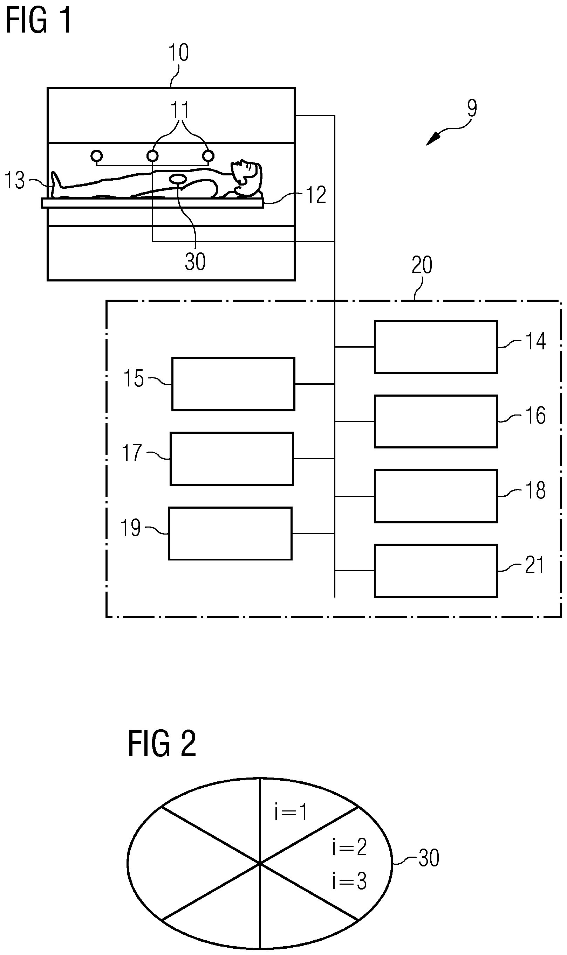

In Bezug auf Figur 1 wird eine Magnetresonanzanlage, MR-Anlage, erläutert, mit der, wie nachfolgend erläutert wird, ein optimiertes MR-Bild mit einem optimierten Bildqualitätsparameter wie beispielsweise dem Kontrast aufgenommen werden kann, ohne die Anwesenheit einer erfahrenen Bedienperson. Die MR-Anlage 9 weist einen Magneten 10 zur Erzeugung eines Polarisationsfeldes $B_0$ auf, wobei eine auf einer Liege 12 angeordnete Untersuchungsperson 13 in den Magneten 10 gefahren wird, um dort ortskodierte Magnetresonanzsignale mit Hilfe von Empfangsspulen 11 aufzunehmen. Durch Einstrahlen von Hochfrequenzpulsen und Schalten von Magnetfeldgradienten kann die durch das Polarisationsfeld $B_0$ erzeugte Magnetisierung aus der Gleichgewichtslage ausgelenkt und ortskodiert werden, und die sich ergebende Magnetisierung wird von den Empfangsspulen 11 detektiert. Wie durch Einstrahlen der HF Pulse und durch Schalten von den Magnetfeldgradienten in verschiedenen Richtungen und Reihenfolgen MR-Bilder erzeugt werden können, ist dem Fachmann grundsätzlich bekannt und wird hier nicht näher erläutert. Im vorliegenden Fall ist es wünschenswert, von der Untersuchungsperson 13 in einem Interessenbereich 30, einer sogenannten Region of Interest, ROI, ein optimiertes MR-Bild aufzunehmen, mit dem eine Fragestellung, wie beispielsweise welche Tumorart vorliegt, optimal beantwortet werden kann.

Die MR-Anlage 9 weist weiterhin eine Steuereinheit 20 auf, die zur Steuerung der MR-Anlage 9 verwendet werden kann. Die Steuereinheit 20 weist eine HF-Steuereinheit 14 für die Steuerung und Generierung der HF-Pulse zur Auslenkung der Magnetisierung auf. Weiterhin ist eine Gradientensteuereinheit 15 vorgesehen zur Steuerung und Schaltung der notwendigen Magnetfeldgradienten. Eine Bildsequenzsteuerung steuert die Abfolge der Magnetfeldgradienten, der Signaldetektion und der HF-Pulse und damit indirekt die Gradientensteuereinheit 15, die HF Steuereinheit 14, und die Empfangsspulen 11. Über eine Eingabeeinheit 17 kann eine Bedienperson die MR-Anlage 9 steuern, und auf eine Anzeigeeinheit 18 können MR-Bilder oder sonstige zur Steuerung notwendigen Informationen angezeigt werden. Eine Recheneinheit 19 mit mindestens einer Prozessoreinheit ist vorgesehen zur Steuerung der verschiedenen Einheiten in der Steuereinheit 20. Weiterhin ist eine Speichereinheit 21 vorgesehen, in der beispielsweise Programmmodule bzw. Programmmittel abgespeichert sein können, die, wenn sie von der Recheneinheit 19 bzw. der Prozessoreinheit ausgeführt werden, den Ablauf der MR-Anlage 9 steuern können. Die Steuereinheit 20 ist wie nachfolgend läutet wird ausgebildet, ein optimiertes MR-Bild eines Untersuchungsobjekts zu erzeugen unter Verwendung von mehreren MR-Testbildern in denen jeweils zumindest ein Qualitätsparameter bestimmt wird.

Wie nachfolgend beschrieben wird, wird eine automatische Optimierung der Einstellungen der Bildgebungssequenz vor der eigentlichen Messung vorgenommen, so dass ein optimiertes MR-Bild erstellt werden kann. Hierfür kann folgender Ablauf durchgeführt werden:

1. Anhand eines sogenannten Localizers oder einer niedrigaufgelösten MR-Aufnahme wird ein Übersichtsbild bzw. ein Bildstapel der Untersuchungsperson aufgenommen, wobei in diesem Bildstapeln ein Interessenbereich abgebildet ist, in dem eine medizinische Fragestellung abgeklärt werden soll.

2. Im nächsten Schritt kann eine Bedienperson eine oder mehrere Interessenbereiche oder Regionen von besonderem Interesse sogenannte Regions of Interest, kurz ROI, auswählen in denen die medizinische Fragestellung besonders von Interesse ist und in denen ein optimaler Bildkontrast wünschenswert ist. Diese Auswahl der ROI(s) kann ebenso automatisch erfolgen. Zur automatischen Identifizierung des Interessenbereich, der ROI, können der MR-Anlage Daten übermittelt werden, die beispielsweise von einem Radiology Information System, RIS, oder einer anderen Datenbank mit Daten von Untersuchungspersonen stammen, oder die Daten enthalten Antworten auf ausgewählte medizinische Fragestellungen. Weiterhin ist es möglich, mithilfe eines neuronalen Netzes den oder die relevanten Interessenbereiche automatisch zu markieren, wobei das normale Netz ebenfalls Daten, beispielsweise vom RIS verwendet. Dies können Untersuchungsperson spezifische Daten sein oder Karten von Untersuchungspersonen mit ähnlicher medizinischer Fragestellung. Hierfür kann zunächst ein neuronales Netz in Abhängigkeit von der medizinischen Fragestellung und der untersuchten Körperregion ausgewählt werden, welches mit bestehenden Daten von Pathologien trainiert wurde. Das neuronale Netz wird in diesem Fall zur Segmentierung genutzt, wie es beispielsweise in Proc. Intl. Soc. Mag. Reson. Med. 26 (2018) von Thomas Küstner et al in "Automated segmentation of abdominal organs in T1- weighted MR images using a deep learning approach: application on a large epidemiological MR Study" beschrieben ist. Mit dem neuronalen Netz wird dann als Ausgabe die ROI bestimmt. Insbesondere sind sogenannte Feed Forward Netze zur Klassifizierung der Interessenbereiche geeignet, wobei die Netze durch die notwendige geringe Datenbasis gut auf derartige Probleme anwendbar sind. Alternativ kann ein Deep Learning Ansatz eingesetzt werden. In beiden Fällen bekommen die Netze als Eingabe Übersichtsbilder oder schnell aufzunehmende Vorabmessungen. Die Netze liefern dann Daten wie Zentrum und grobe Abmessungen des zu untersuchenden Bereichs. Sollte der Kontrast nicht ausreichen, kann auch als Region das ganze Organ ausgewählt werden, wie es in dem oben beschriebenen ISMRM Abstrakt beschrieben ist.

3. In einem nächsten Schritt wird eine Bildgebungssequenz mit variierenden Einstellungen, beispielsweise mit unterschiedlichen Echozeiten TE, Inversionszeiten TI, Repetitionszeiten TR, Kippwinkeln etc. iterativ ausgeführt, wobei versucht wird, einen möglichst hohen Kontrast, beispielsweise contrast to noise ratio, kurz CNR, in dem oder den ausgewählten Interessenbereichen zu erreichen. Die mit den verschiedenen Bildgebungsparametern aufgenommen MR-Bilder werden nachfolgend als MR-Testbilder bezeichnet, da in ihnen überprüft wird, welche Bildgebungsparameter den besten Kontrast oder jeglichen anderen Bildqualitätsparameter wie beispielsweise das Signal-zu-Rauschverhältnis ergeben. Damit dieser Schritt in einer annehmbaren Zeitdauer abgeschlossen ist, können diese MR-Testbilder stark unterabgetastet und beispielsweise niedrig aufgelöst gemessen werden. (Dies wäre z. B. bei einer Auflösung der Matrix in Phasenrichtung von 256 eine Reduktion auf 64, bei im Falle eines PTX System Beibehaltung der Ortsauflösung durch eine Beschränkung des FOV. Zusätzlich ist es möglich, die Messung auf eine einzelne Schicht oder wenige Schichten zu beschränken. Diese Kombination von diesen beiden Beschleunigungen würde z.B. bei einer Schichtanzahl von 40 und einer Reduktion auf 2 Schichten für die Testmessung zu einer Beschleunigung vom Faktor 80 führen. Dies würde selbst bei mehreren Minuten langen Messungen zu Testmessungen im Sekundenbereich führen.

Ebenso ist es möglich, eine oder mehrere Projektionen zu verwenden, bei denen die Magnetfeldgradienten zu Ortskodierung nicht in allen Raumrichtungen geschalten werden, so dass Messzeit gespart werden kann und das Signal in die Richtung ohne Magnetfeldgradient eine Projektion ist. Da hier keine Phasenkodierung mehr notwendig ist, reduziert sich die Zeit im vorherigen Beispiel um den Faktor 256. In Kombination mit der Reduktion der Schichten, sind Aufnahmen von Testprojektion in der Größenordnung von Millisekunden möglich.

Bei schnellen Spinechosequenzen ist es notwendig, die durch die Repetitionszeit TR bedingte Wartezeit zu berücksichtigen. Diese Wartezeit kann umgangen werden durch Verwendung von zyklisch orthogonalen Schichten oder durch Aufnehmen von leicht verschobenen Schichten mit unterschiedlichen Positionen oder geringeren Anregungswinkeln. Diese verschiedenen Optionen können auch kombiniert werden. Bei Bildgebungssequenzen im Gleichgewichtszustand oder kleine Anregungswinkeln ist die Repetitionszeit vernachlässigbar.

In einer weiteren Ausführungsform werden Gewebeparameterkarten entlang der Projektionsrichtung erstellt, z.B. durch systematische Variation von TE und Ableitung von T2-Karten. Dann können die gängigen Relaxationszusammenhänge (z.B. $M(TE)=M(0)*exp(-TE/T2)$) für die Kontrastoptimierung verwendet werden.

Durch die oben beschriebenen verschiedenen Aspekte ist es möglich, jedes MR-Testbild innerhalb von Millisekunden, zumindest jedoch in einem Zeitbereich unter 1 Sekunde aufzunehmen.

Bei besonders kleinen Pathologien kann bei der Erstellung der MR-Testbilder nur ein sehr geringer Abschnitt des Untersuchungsobjekts um den Interessenbereich herum gezeigt werden, so dass dieser Bereich bei geringer Messdauer auch mit einer Auflösung aufgenommen werden kann, die in etwa der Auflösung entspricht, in der nachher das optimierte MR-Bild aufgenommen werden soll. Für jedes MR-Testbild wird ein Bildgebungsparametersatz mit TE, TI, TR, Kippwinkel, Auflösung etc. verwendet und einige kontrastbestimmende Parameter können innerhalb eines definierten Wertebereichs in diskreten Werten geändert werden, umso einen Parameterraum mit Messungen zu füllen, der durch die verschiedenen Bildgebungsparameter und die verwendeten Parameterwerte definiert ist. Es ist beispielsweise möglich bei der Optimierung beispielsweise Vorwissen aus bestehenden Datensätzen zu verwenden, um die optimalen Bildgebungsparameter schneller zu finden. Hierbei könnte beispielsweise mit einem Gradientenabstiegsverfahren der aktuell abgetastete Parameterraum mit dem Parameterraum von anderen Datensätzen verglichen werden. Als Zielfunktion kann hierbei der Kontrast verwendet werden. Die Zielfunktion $g_{ROI}$ kann beispielsweise das Maximum der Ableitung eines Profils durch die ROI sein. Figur 2 zeigt schematisch den Interessenbereich oder die ROI 30, wobei drei verschiedene Profile durch die ROI gelegt werden und die Signalintensität entlang der Profile betrachtet wird. Durch Ableitung der Profile kann beispielsweise der beste Kontrast berechnet werden, d.h. die größte Intensitätsänderung. Eine mögliche Zielfunktion lautet dann wie folgt

$$g_{roi} = \sum_{i=1}^{N} \max\left(\frac{d}{dx} profil_i(x)\right) \qquad (1)$$

$g_{ROI}$ ist hierbei die Zielfunktion und *profil_i(x)* ist das Profil durch die ROI, wie es in Figur 2 für drei verschiedene Beispiel gezeigt ist. Eine weitere Möglichkeit zur Verwendung einer Zielfunktion ist die Verwendung der Standardabweichung, wie es durch folgende Definition der Zielfunktion gezeigt ist:

$$g_{roi} = \sum_{i=1}^{N} \frac{\max\left(\mathtt{profil}_i(x)\right) - \min\left(\mathtt{profil}_i(x)\right)}{\sigma_{\mathrm{std}}\left(\mathtt{profil}_i(x)\right)} \qquad (2)$$

$\sigma_{std}$ ist hierbei die Standardabweichung im Profil.

Gleichung 2 entspricht hierbei der Summe der maximalen Kontrastverhältnisse, CNR der Profile.

Durch Berechnung von zumindest einer der obigen Größen in den verschiedenen Testbildern kann das Testbild identifiziert werden, das den besten Bildqualitätsparameter hat. Wurden in den Übersichtsbildern bereits konkrete Pathologien markiert, so kann eine Maximierung des Kontrasts zwischen den markierten Pathologien und deren direkter Umgebung erfolgen. Dann kann das Profil auf einen Teil der Pathologie und der Umgebung eingeschränkt werden, oder es können statt Profile direkt die Signalintensitäten von ROIs in der Pathologie und der Umgebung miteinander verglichen werden.

Weiterhin ist es möglich, auch hier einen Deep Learning Ansatz zu verwenden, welcher intrinsisch durch das Training auf Vorwissen aus bestehenden Datensätzen zurückgreift. Beispielsweise kann zum Transfer von Testdatensätzen auf optimalen Kontrast wie folgt vorgegangen werden:

- Testdatensätze mit variierenden Bildgebungsparametern wie oben beschrieben sowie mehrere Aufnahmen einer Bildgebungssequenz mit variierenden Bildgebungsparametern werden als Trainingsdaten verwendet.
- Ein erfahrener Radiologe wählt aus den Bildgebungssequenzen diejenige mit dem optimalen Kontrast aus.
- Das Netz lernt den Zusammenhang zwischen Testdatensätzen und optimalen Kontrastparametern.
- Hier kann als Freiheitsgrad die Art der Pathologie mit einfließen.
- Dies hat den Vorteil, dass das Kontrastverhalten in Testdatensätzen vom Kontrastverhalten in den Bilddatensätzen abweichen kann, das Netz erkennt den Zusammenhang.

Hierbei können MR-Bilder für die verschiedenen Pathologien aufgenommen werden und von Bedienpersonen bewertet werden. Diese kann dann zum Training des neuronalen Netzes verwendet werden. Alternativ können auch Messungen mit den Zielfunktionen wie beim schon erwähnten Gradientenabstiegsverfahren als Bewertung verwendet werden, um so das Netz zu trainieren.

Durch die hier beschriebenen Verfahren kann mit wenigen Variationen der Bildgebungsparameter eine Optimierung durchgeführt werden um das MR-Bild unter den MR-Testbildern zu finden, das den besten Bildqualitätsparameter aufweist, wobei dieses MR-Bild als erstes MR-Bild bezeichnet wird.

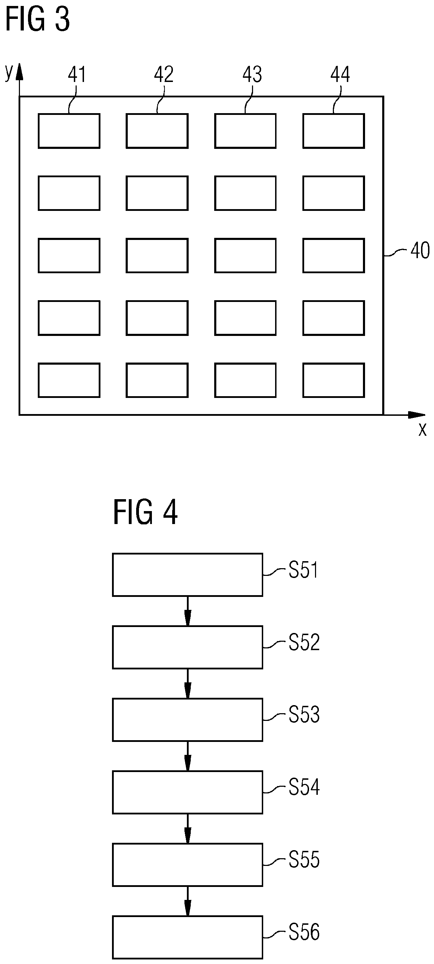

Ebenso ist es alternativ zur automatischen Auswertung bei besonderen Messungen wie Dynamikmessungen mit Kontrastmittelgabe oder längeren 3D Messungen auch eine manuelle Auswahl möglich. Wie in Figur 3 gezeigt ist, wird hierbei die Serie der aufgenommenen MR-Testbilder der Bedienperson angezeigt, bei beispielsweise in Form einer Bildmatrix wie der Matrix 40 mit den einzelnen MR-Testbildern 41-44. In der Matrix werden in Richtung der beiden Achsen jeweils einer der Bildgebungsparameter wie Echozeit und in die andere Achsenrichtung ein anderer Bildgebungsparameter variiert. Die Bedienperson kann dann durch Auswählen eines der MR-Testbilder 41-44 den gewünschten Kontrast wählen.

4. In einem weiteren Schritt kann dann nach der Optimierung der Auswahl des MR-Testbildes mit den besten Kontrast das eigentliche MR-Bild, das optimierte MR-Bild aufgenommen werden mit den zuvor ermittelten Bildgebungsparametern. Hierbei entsprechen zumindest die Bildgebungsparameter, die im Wesentlich den Kontrast beeinflussen mit den Bildgebungsparameter des ersten MR-Testbildes überein, die anderen Parameter, die insbesondere die Auflösung bestimmen, können anders sein als bei der Aufnahme des ersten MR-Testbildes.

Bei der Vorauswahl der Bildgebungssequenz für die MR-Testbilder sind verschiedene Möglichkeiten denkbar. Eine Möglichkeit besteht darin, die Optimierung auf einzelne physikalische Parameter zu beschränken, wie beispielsweise eine T1 oder eine T2 Gewichtung zu erzwingen. Dazu wird vorab die zur optimierenden Sequenz vorgegeben, sei es eine schnelle Spinnechosequenz oder eine Gradientenechosequenz, wodurch auch ein sinnvoller Wertebereich für die Bildgebungsparameter feststeht.

Weiterhin ist es möglich, die Optimierung frei in der Bildgebungssequenzwahl zu lassen und so zum Beispiel für eine Diffusionswichtung eine echoplanar Bildgebungssequenz, EPI Sequenz, zu verwenden und falls hier kein ausreichender Kontrast erreicht wird, eine andere Sequenz zu verwenden wie beispielsweise eine EPI basierte Spin-Echo Sequenz oder alternativ hierzu eine schnelle Spinnechosequenz für eine T2 Wichtungen oder eine Gradientenechosequenz für eine T1 Richtung.

Figur 4 fasst die wesentlichen Schritte des Verfahrens zusammen. In einem Schritt S51 wird zumindest ein MR-Übersichtsbild des Untersuchungsobjekts aufgenommen, in dem das Interessengebiet abgebildet ist. In einem Schritt S52 wird der Interessenbereich, die ROI, auf dem MR-Übersichtsbilds bestimmt, wobei von diesem Interessenbereich das optimierte MR-Bild so ausgebildet sein soll, dass dort der bestmögliche Kontrast erreicht wird. In einem Schritt S53 werden anschließend die mehreren MR-Testbilder mit jeweils einem Bildgebungsparametersatz aufgenommen, wobei für die verschiedenen MR-Testbilder die Bildgebungsparameter in definierten Bereichen variiert werden zur Erstellung der verschiedenen MR-Testbilder. In einem Schritt S54 erfolgt schließlich das Bestimmen des Bildqualitätsparameters in dem Interessenbereich, beispielsweise wie in Zusammenhang mit Figur 2 beschrieben zur Bestimmung eines Profils und der Nachverarbeitung des Profils zur Bestimmung des Bildqualitätsparameter wie die Ableitung der Steigung. In einem Schritt S54 erfolgt dann die Bestimmung der Bildqualitätsparameter in den verschiedenen MR-Testbildern und in einem Schritt S55 wird das erste MR-Testbild unter den Testbildern bestimmt, das den besten Bildqualitätsparametersatz aufweist. Der erste Bildgebungsparameter wird bestimmt, mit dem dieses erste MR-Testbild aufgenommen wurde und in einem Schritt S56 erfolgt die Aufnahme des optimierte MR-Bildes mit einem optimierten Bildparametersatz, wobei diese Parameter in der Mehrzahl von dem ersten Bildgebungsparametersatz kommen, mit dem das erste MR-Testbild aufgenommen wurde.

Die Aufnahme des optimierten MR-Bildes erfolgt während einer Dauer, die größer ist als die Dauer für die Aufnahme aller MR-Testbilder.

Zusammenfassend erlaubt das oben beschriebene Verfahren eine schnelle Optimierung innerhalb von wenigen Sekunden der Bildgebungssequenz auf ausgewählte Bereiche. Dies kann beispielsweise insbesondere bei Messungen relevant sein, die mehrere Minuten dauern oder Kontrastmittelgabe bedingen und deswegen nicht einfach wiederholt werden können. Ein Vorteil des beschrieben Verfahrens liegt darin, dass eine höhere Unabhängigkeit erreicht wird von der Erfahrung der Bedienperson und trotzdem eine hohe Bildqualität gewährleistet werden kann. Bei der vollständig automatisiert ablaufenden Auswahl der Bildgebungssequenz und des Interessenbereichs kann auf eine erfahrene Bedienperson verzichtet werden. Ebenso ist es möglich eine deutlich höhere Automatisierung der Messungen zu erreichen.

Ein weiterer Vorteil liegt in der Optimierung auf einzelne Fragestellungen, wodurch der erzielte Kontrast vorab optimiert werden kann und somit Fehldiagnosen verringert werden und Wiederholungen verwendet werden.

## Patentansprüche

1. Verfahren zum Aufnehmen von einem optimierten MR-Bild eines Untersuchungsobjekts in einer Magnetresonanzanlage (9), mit den folgenden Schritten:

   - Bestimmen von zumindest einem MR-Übersichtsbild des Untersuchungsobjekts,
   - Bestimmen von wenigstens einem Interessenbereich (30) im Untersuchungsobjekt auf dem MR-Übersichtsbild, der in dem optimierten MR-Bild dargestellt sein soll,
   - Aufnehmen von mehreren MR-Testbildern (41-44) mit jeweils einem Bildgebungsparametersatz, wobei sich die Bildgebungsparametersätze bei den mehreren MR-Testbildern in zumindest einem Bildgebungsparameter unterscheiden, und wobei in den MR-Testbildern der Interessenbereich abgebildet ist,
   - Bestimmen von einem Bildqualitätsparameter in dem Interessenbereich in den mehreren MR-Testbildern,
   - Bestimmen eines ersten MR-Testbildes unter den MR-Testbildern, das den besten Bildqualitätsparameter aufweist und Bestimmen von einem ersten Bildgebungsparametersatz, der bei dem ersten MR-Testbild verwendet wurde,
   - Aufnehmen des optimierten MR-Bildes mit einem optimierten Bildgebungsparametersatz, bei dem eine Mehrzahl der verwendeten Bildgebungsparametern den Bildgebungsparametern des ersten Bildgebungsparametersatzes entspricht, wobei eine Dauer für die Aufnahme des optimierten MR-Bildes größer ist als die Dauer für die Aufnahme der mehreren MR Testbilder.

2. Verfahren nach Anspruch 1, wobei jeder Bildgebungsparametersatz kontrastbestimmende Parameter, die überwiegend einen Kontrast von aufgenommenen MR-Bildern bestimmen, und auflösungsbestimmende Parameter, die überwiegend eine Auflösung von den aufgenommenen MR-Bildern bestimmt, aufweist, wobei die kontrastbestimmenden Parameter des ersten Bildgebungsparametersatz für die Aufnahme des optimierten MR-Bildes verwendet werden.

3. Verfahren nach Anspruch 1 oder 2, **dadurch gekennzeichnet, dass** der Bildqualitätsparameter ein Kontrastverhältnis aufweist, das im Interessenbereich in den mehreren MR-Testbildern bestimmt wurde, wobei das erste MR-Testbild das MR-Testbild mit dem höchsten Kontrastverhältnis in dem Interessenbereich ist.

4. Verfahren nach einem der vorstehenden Ansprüche, **dadurch gekennzeichnet, dass** eine Auflösung bei den MR-Testbildern (41-44) geringer ist als die Auflösung des optimierten MR-Bildes.

5. Verfahren nach einem der vorstehenden Ansprüche, **dadurch gekennzeichnet, dass** der Interessenbereich (30) automatisch ausgewählt wird unter Verwendung von Antwortdaten, die Antworten auf medizinische Fragestellungen aufweisen, die der MR-Anlage zugeführt wurden.

6. Verfahren nach Anspruch 5, **dadurch gekennzeichnet, dass** der Interessenbereich (30) automatisch von einem neuronalen Netzwerk bestimmt wird, dem die Antwortdaten zugeführt wurden.

7. Verfahren nach einem der vorstehenden Ansprüche, **dadurch gekennzeichnet, dass** bei der Aufnahme der MR-Testbilder (41-44) Projektionsbilder erzeugt werden, die mit Magnetfeldgradienten in weniger Raumrichtungen aufgenommen werden als bei der Aufnahme des optimierten MR Bildes.

8. Verfahren nach einem der vorstehenden Ansprüche, **dadurch gekennzeichnet, dass** mit den unterschiedlichen Bildgebungsparametern der MR-Testbilder ein Parameterraum aufgespannt wird, der mit den MR Testbildern, die mit unterschiedlichen Bildgebungsparametern aufgenommen wurden, abgetastet wird, wobei für die Bestimmung des ersten MR-Testbildes frühere Parameterräume und frühere erste Bildgebungsparametersätze verwendet werden, die bei der Bestimmung von früheren optimierten MR-Bildern verwendet werden, um bei der Abtastung des Parameterraums den Punkt im Parameterraum zu finden, der dem besten Bildqualitätsparameter im Interessenbereich entspricht.

9. Verfahren nach Anspruch 8, **dadurch gekennzeichnet, dass** das erste MR-Testbild bestimmt wird unter Verwendung eines neuronalen Netzes, das mit den früheren Parameterräumen und den früheren ersten Bildgebungsparametersätzen trainiert wurde.

10. Verfahren nach einem der vorstehenden Ansprüche, **dadurch gekennzeichnet, dass** das optimierte MR-Bild in mehreren Schichten des Untersuchungsobjekt aufgenommen wird, wobei jedes der MR-Testbilder in einer geringeren Anzahl von Schichten aufgenommen wird als das optimale MR-Bild.

11. Verfahren nach einem der vorstehenden Ansprüche, **dadurch gekennzeichnet, dass** zur Bestimmung des Bildqualitätsparameters zumindest ein Profil der Signalintensität im Interessenbereich bestimmt wird, wobei der Bildqualitätsparameter anhand des zumindest einen Profils bestimmt wird.

12. Verfahren nach Anspruch 11, **dadurch gekennzeichnet, dass** eine Zielfunktion bestimmt wird, die das zumindest eine Profil aufweist, wobei zur Bestimmung des ersten MR-Testbildes auf die Zielfunktion ein Optimierungsverfahren angewandt wird.

13. Magnetresonanzanlage (9), die ausgebildet ist, zur Aufnahme von MR-Bildern, wobei die MR-Anlage, eine Steuereinheit (20) und eine Speichereinheit (21) aufweist, wobei die Speichereinheit von der Steuereinheit ausführbare Steuerinformationen speichert, wobei die MR-Anlage ausgebildet ist, bei Ausführung der Steuerinformationen in der Steuereinheit ein Verfahren nach einem der Ansprüche 1 bis 12 durchzuführen.

14. Computerprogrammprodukt, welches Programmmittel umfasst und direkt in eine Speichereinheit einer programmierbaren Steuereinheit einer Magnetresonanzanlage ladbar ist, um alle Schritte des Verfahrens nach einem der Ansprüche 1-12 auszuführen, wenn die Programmmittel in der Steuereinheit ausgeführt werden.

15. Elektronisch lesbarer Datenträger mit darauf gespeicherten elektronisch lesbaren Steuerinformationen, welche derart ausgestaltet sind, dass sie bei Verwendung des Datenträgers in einer Steuereinheit einer Magnetresonanzanlage ein Verfahren nach einem der Ansprüche 1-12 durchführen.

## FIG 1

10

11

13

12

9

30

20

15

14

17

16

19

18

21

## FIG 2

i = 1

i = 2

i = 3

30

## FIG 3

41    42    43    44

40

## FIG 4

S51

S52

S53

S54

S55

S56

**Europäisches Patentamt**
**European Patent Office**
**Office européen des brevets**

# EUROPÄISCHER RECHERCHENBERICHT

**Nummer der Anmeldung**

EP 18 18 3865

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X<br>Y | EP 1 288 671 A2 (TOSHIBA KK [JP])<br>5. März 2003 (2003-03-05)<br>* Abbildungen 3,4 *<br>* Absatz [0010] - Absatz [0012] *<br>* Absatz [0033] - Absatz [0034] *<br>* Absatz [0040] *<br>* Absatz [0054] - Absatz [0055] *<br>* Absatz [0064] *<br>* Absatz [0069] - Absatz [0070] *<br>----- | 1-4,7,8,<br>10-15<br>5,6,9 | INV.<br>G01R33/54<br>G06K9/32 |
| Y | EP 2 194 486 A1 (KONINKL PHILIPS ELECTRONICS NV [NL])<br>9. Juni 2010 (2010-06-09)<br>* Abbildung 1 *<br>* Absatz [0017] *<br>* Anspruch 1 *<br>* Absatz [0004] - Absatz [0005] *<br>----- | 5,6 | |
| Y | EP 3 282 271 A1 (SIEMENS HEALTHCARE GMBH [DE]) 14. Februar 2018 (2018-02-14)<br>* Anspruch 1 *<br>* Absatz [0015] - Absatz [0018] *<br>----- | 9 | RECHERCHIERTE SACHGEBIETE (IPC) |
| A | DE 10 2008 050030 A1 (SIEMENS AG [DE])<br>22. April 2010 (2010-04-22)<br>* Abbildung 2 *<br>* Absatz [0033] - Absatz [0039] *<br>----- | 1-15 | G01R<br>G06K |

Der vorliegende Recherchenbericht wurde für alle Patentansprüche erstellt

| Recherchenort | Abschlußdatum der Recherche | Prüfer |
|---|---|---|
| München | 18. Januar 2019 | Durst, Markus |

**ANHANG ZUM EUROPÄISCHEN RECHERCHENBERICHT
ÜBER DIE EUROPÄISCHE PATENTANMELDUNG NR.**

EP 18 18 3865

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

18-01-2019

| Im Recherchenbericht angeführtes Patentdokument | Datum der Veröffentlichung | Mitglied(er) der Patentfamilie | Datum der Veröffentlichung |
|---|---|---|---|
| EP 1288671 A2 | 05-03-2003 | CN 1403054 A | 19-03-2003 |
| | | CN 1775173 A | 24-05-2006 |
| | | EP 1288671 A2 | 05-03-2003 |
| | | EP 1983350 A2 | 22-10-2008 |
| | | JP 5002099 B2 | 15-08-2012 |
| | | JP 2003070766 A | 11-03-2003 |
| | | US RE43637 E | 11-09-2012 |
| | | US RE43784 E | 06-11-2012 |
| | | US 2003042905 A1 | 06-03-2003 |
| EP 2194486 A1 | 09-06-2010 | CN 102239495 A | 09-11-2011 |
| | | EP 2194486 A1 | 09-06-2010 |
| | | EP 2374092 A1 | 12-10-2011 |
| | | US 2011229005 A1 | 22-09-2011 |
| | | WO 2010064187 A1 | 10-06-2010 |
| EP 3282271 A1 | 14-02-2018 | CN 107693017 A | 16-02-2018 |
| | | EP 3282271 A1 | 14-02-2018 |
| | | US 2018038930 A1 | 08-02-2018 |
| DE 102008050030 A1 | 22-04-2010 | DE 102008050030 A1 | 22-04-2010 |
| | | US 2010085051 A1 | 08-04-2010 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **THOMAS KÜSTNER et al.** Automated segmentation of abdominal organs in T1- weighted MR images using a deep learning approach: application on a large epidemiological MR Study. *Proc. Intl. Soc. Mag. Reson. Med.,* 2018, vol. 26